# EUROPÄISCHE PATENTSCHRIFT

(11) **EP 0 627 117 B1**
(45) Veröffentlichungstag und Bekanntmachung des Hinweises auf die Patenterteilung: **27.09.1995**
(21) Anmeldenummer: 93902065.7
(22) Anmeldetag: 01.02.1993
(51) Int. Cl.: G11C 11/408

(54) **SCHALTUNGSANORDNUNG ZUM ZWISCHENSPEICHERN EINES BITS UND DEREN VERWENDUNG ALS ADRESSZWISCHENSPEICHER**
CIRCUIT FOR THE BUFFER STORAGE OF A BIT, AND USE OF THE CIRCUIT AS AN ADDRESS BUFFER STORE
CIRCUIT POUR LA MISE EN MEMOIRE INTERMEDIAIRE D'UN BIT ET UTILISATION DE CE CIRCUIT COMME MEMOIRE INTERMEDIAIRE D'ADRESSES

(30) Priorität: 21.02.1992 DE 4205339
(43) Veröffentlichungstag der Anmeldung: 07.12.1994
(73) Patentinhaber: SIEMENS AKTIENGESELLSCHAFT, 80333 München (DE)
(72) Erfinder: GEIB, Heribert, D-85567 Grafing (DE)
(86) Internationale Anmeldenummer: DE9300076
(87) Internationale Veröffentlichungsnummer: WO9317434

(56) Entgegenhaltungen:
- EP-A- 0 361 807
- EP-A- 0 478 252
- US-A- 4 156 940
- US-A- 4 754 165
- US-A- 5 003 513

## Beschreibung

### Schaltungsanordnung zum Zwischenspeichern eines Bits und deren Verwendung als Adreßzwischenspeicher.

In Speicherbausteinen werden zur Adressierung einzelner DRAM-Speicherzellen Bits an die Adresseingänge des Speicherbausteins angelegt. Um sicherzustellen, daß nach dem Anlegen einer gültigen Adresse Änderungen an dem Adresseingang keinen Einfluß auf die Adresse ausüben, wird das der Adresse entsprechende Bit zwischengespeichert. Das Signal wird dabei in der Regel auf CMOS-Pegel gewandelt.

Nach dem Zwischenspeichern des angelegten Bits werden die Adresseingänge vom weiteren Signalpfad abgetrennt.

Eine dabei verwendete Schaltungsanordnung wird als Adreßzwischenspeicher oder Adreßlatch bezeichnet. Sie findet Anwendung für Zeilen-Adressen, Spalten-Adressen und im Bereich des Dateneinschreibens.

Aus der europäischen Patentanmeldung EP 0 361 807 A2 ist ein Schieberegister bekannt, das mit Hilfe zweier Phasensignale gesteuert wird. Das Schieberegister umfaßt zwei Module, die im wesentlichen identisch sind und die in Serie zwischen Eingang und Ausgang verschaltet sind, wobei jedes Modul vier Transistoren umfaßt und jeweils nur ein Phasensignal erfordert.

Aus US-PS 4 156 940 ist eine Speicheranordnung mit einem Spannungsgenerator bekannt. In der Anordnung wird der Speicherinhalt über einen Transistor ausgelesen, dessen Impedanz im eingeschalteten Zustand über einen von einem Spannungsteiler zur Verfügung gestellten Pegel gesteuert wird.

Aus US-PS 4 754 165 ist ein statischer MOS-Zwischenspeicher bekannt. Die Anordnung umfaßt einen Ausgang und einen invertierten Ausgang, die jeweils zwischen zwei in Serie geschalteten MOS-Transistoren abgenommen werden, die zwischen den höheren Spannungspegel und den niedrigeren Spannungspegel in Serie geschaltet sind. Angesteuert werden die in Serie geschalteten MOS-Transistoren jeweils von einem Eingang und einem invertierten Eingang, so daß bei Anliegen eines Signals entsprechend dem höheren Pegel der Ausgang mit der Spannung entsprechend dem höheren Pegel verbunden wird und gleichzeitig der invertierte Ausgang mit der Spannung entsprechend dem geringeren Pegel und umgekehrt.

Aus der nachveröffentlichten, älteren europäischen Patentanmeldung EP 0 478 252 A2 ist eine Speicheranordnung bekannt, die unter anderem Adreßzwischenspeicher umfaßt. In dem Zwischenspeicher wird ein Eingangssignal über ein NOR-Glied an den Eingang eines Speichergliedes gelegt.

Der Erfindung liegt das Problem zugrunde, eine Schaltungsanordnung zum Zwischenspeichern eines Bits anzugeben, die mit einer möglichst geringen Anzahl von Transistoren aufgebaut ist und die daher einen geringen Platzbedarf aufweist.

Das Problem wird erfindungsgemäß gelöst durch eine Schaltungsanordnung nach Anspruch 1, weitere Ausgestaltungen der Erfindung gehen aus den übrigen Ansprüchen hervor.

In der erfindungsgemäßen Schaltungsanordnung wird der Eingang über einen einzelnen Transistor, zum Beispiel einen MOS-Transistor mit dem Speicherglied verbunden, in dem das Bit zwischengespeichert wird. Das Speicherglied umfaßt Mittel, durch die ein Ausgangssignal am Ausgang des Speicherglieds in Abhängigkeit vom Pegel eines dem Bit entsprechenden Eingangssignals auf vorgegebenes Potential gebracht wird. Auf diese Weise wird ein Verlust an Signalhöhe des Eingangssignals beim Durchschalten einer logischen 1 an dem ersten Transistor ausgeglichen.

Das Speicherglied umfaßt zum Beispiel einen Inverter und einen PMOS-Transistor, dessen Gate-Elektrode durch das invertierte Signal selbst angesteuert wird und der im leitenden Zustand den Eingang des Inverters mit einer Versorgungsspannungsquelle, die ein dem höheren Pegel entsprechendes Potential liefert, verbindet.

Es liegt im Rahmen der Erfindung, einen weiteren NMOS-Transistor vorzusehen, der von dem invertierten Eingangssignal angesteuert wird und der im leitenden Zustand den Eingang des Speichergliedes mit einer Versorgungsspannungsquelle, die ein dem niedrigen Pegel entsprechendes Potential liefert, verbindet. Auf die Weise werden auch Störungen des Ausgangssignals ausgeglichen, wenn das Eingangssignal den Wert einer logischen O annimmt.

Es liegt im Rahmen der Erfindung, einen Adreßzwischenspeicher aus zwei erfindungsgemäßen Schaltungsanordnungen aufzubauen. Der einen Schaltungsanordnung wird das digitale Eingangssignal über einen Inverter zugeführt. Beide Schaltungsanordnungen werden gemeinsam von dem ersten Steuersignal angesteuert. Am Ausgang des Adreßzwischenspeichers stehen ein Ausgangssignal und ein invertiertes Ausgangssignal zu Verfügung.

Durch Aufbau der erfindungsgemäßen Schaltung mit einem NMOS- Transistor am Adresseingang und einem PMOS-Transistor und einem Inverter als Speicherglied ist nur das erste Steuersignal erforderlich, um das Bit auf den Eingang des Speichergliedes zu schalten.

Es ist vorteilhaft, in der Ausführungsform mit den NMOS-Transistoren zur Entstörung des niedrigen Pegels in dem Adreßzwischenspeicher die Gate-Elektroden der NMOS-Transistoren kreuzweise durch das Eingangssignal und das invertierte Eingangssignal anzusteuern. Dadurch wird eine höhere Störsicherheit gewährleistet.

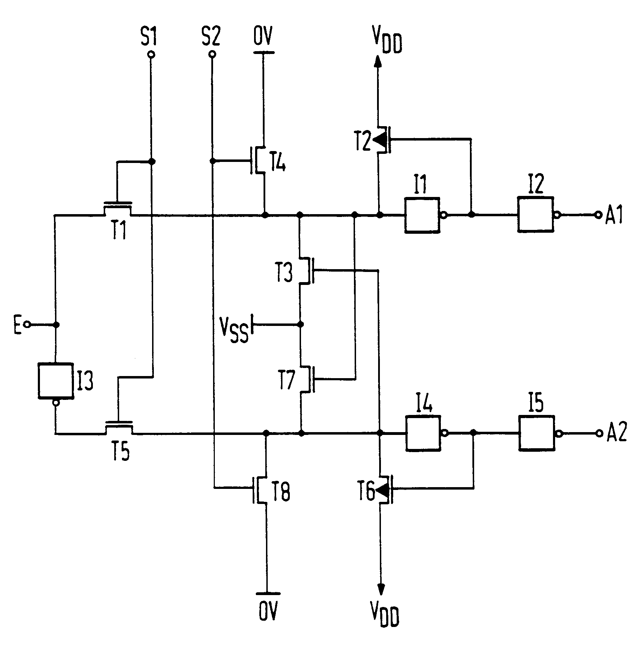

Im folgenden wird die Erfindung anhand eines Ausführungsbeispiels und der Figur näher erläutert.

In der Figur ist eine Schaltungsanordnung zum Zwischenspeichern eines digitalen Signals dargestellt.

Ein Eingang E ist mit dem ersten Anschluß eines ersten MOS- Transistors T1 verbunden. Der ersten MOS-Transistor T1 ist zum Beispiel ein n-Kanal-Transistor. Die Gate-Elektrode des ersten MOS-Transistors T1 wird durch ein erstes Steuersignal S1 angesteuert.

Es ist ein zweiter MOS-Transistor T2 vorgesehen, dessen erster Anschluß mit einer ersten Versorgungsspannungsquelle VDD verbunden ist. Der zweite Anschluß des zweiten MOS- Transistors T2 ist mit dem zweiten Anschluß des ersten MOS- Transistors T1 verbunden. Der zweite MOS-Transistor T2 ist ein p-Kanal-Transistor.

Es ist ein erster Inverter I1 vorgesehen, dessen Eingang mit dem zweiten Anschluß des ersten MOS-Transistors T1 und des zweiten MOS-Transistors T2 verbunden ist. Der Ausgang des ersten Inverters I1 ist mit der Gate-Elektrode des zweiten MOS-Transistors T2 verbunden.

Da der zweite MOS-Transistor T2 ein p-Kanal-Transistor ist, schaltet der zweite MOS-Transistor T2 durch, wenn an dem zweiten Anschluß des ersten MOS-Transistors T1 das Eingangssignal den höheren Pegel hat und folglich am Ausgang des ersten Inverters I1 der geringere Pegel (low-Pegel) anliegt. In diesem Fall wird das Potential am Eingang des ersten Inverters I1 über den zweiten MOS-Transistor T2 auf das Potential der Versorgungsspannung VDD gezogen. Dadurch wird der Verlust einer Einsatzspannung über dem ersten MOS-Transistor T1 kompensiert, falls eine "1" am Eingang anliegt.

Der Ausgang des ersten Inverters I1 ist mit dem Eingang eines zweiten Inverters I2 verbunden. Der Ausgang des zweiten Inverters I2 ist mit einem Ausgang A1 verbunden. Am Ausgang A1 steht ein Ausgangssignal zur Verfügung, das dem Eingangssignal entspricht.

Es ist ein dritter MOS-Transistor T3 vorgesehen, der ein n- Kanal-Transistor ist und dessen erster Anschluß mit dem zweiten Anschluß des ersten MOS-Transistors verbunden ist und dessen zweiter Anschluß mit einer zweiten Versorgungsspannungsquelle V_{SS}, die ein Potential entsprechend dem niedrigen Pegel des Ausgangssignals aufweist, verbunden, die Gateelektrode des dritten MOS-Transistors T3 wird von dem invertierten Eingangssignal angesteuert.

Es ist ein vierter MOS-Transistor T4 vorgesehen, der zum Beispiel ein n-Kanal-Transistor ist. Der erste Anschluß des vierten MOS-Transistors T4 ist mit dem zweiten Anschluß des ersten MOS-Transistors T1 verbunden. Der zweite Anschluß des vierten MOS-Transistors T4 ist mit Massepotential verbunden. Über die Gate-Elektrode des vierten MOS-Transistors T4 wird ein zweites Steuersignal 52 angelegt.

Parallel zu dem ersten MOS-Transistor T1 ist der Eingang E mit einem dritten Inverter I3 verbunden. Der Ausgang des dritten Inverters I3 ist mit dem ersten Anschluß eines fünften MOS- Transistors T5 verbunden. Der fünfte MOS-Transistor T5 ist auch zum Beispiel ein n-Kanal-Transistor. Die Gate-Elektrode des fünften MOS-Transistors T5 wird ebenfalls von dem ersten Steuersignal S1 angesteuert.

Es ist ein sechster MOS-Transistor T6 vorgesehen, der ebenfalls ein p-Kanaltransistor ist. Der erste Anschluß des sechsten MOS-Transistors T6 ist mit der ersten Versorgungsspannungsquelle VDD verbunden. Der zweite Anschluß des sechsten MOS- Transistors T6 ist mit dem zweiten Anschluß des fünften MOS- Transistors T5 verbunden.

Es ist ein vierter Inverter 14 vorgesehen, dessen Eingang mit dem zweiten Anschluß des fünften MOS-Transistors T5 und dem zweiten Anschluß des sechsten MOS-Transistors T6 verbunden ist. Der Ausgang des vierten Inverters I4 ist mit der Gate- Elektrode des sechsten MOS-Transistors T6 verbunden.

Da der sechste MOS-Transistor T6 ein p-Kanal-Transistor ist, wird der sechste MOS-Transistor T6 durchgeschaltet, wenn am Ausgang des vierten Inverters I4 niedriger Spannungspegel (low-Pegel) anliegt und damit am Eingang des vierten Inverters I4 ein Signal mit hohem Spannungspegel anliegt. Beim Durchschalten einer logischen 1 wird diese daher über den sechsten MOS-Transistor T6 auf das Potential der Versorgungsspannung VDD angezogen.

Es ist ein fünfter Inverter I5 vorgesehen, dessen Eingang mit dem Ausgang des vierten Inverters I4 verbunden ist. Der Ausgang des fünften Inverters I5 ist mit einem invertierten Ausgang A2 verbunden. An dem invertierten Ausgang A2 liegt in Bezug auf den Ausgang A1 das invertierte Ausgangssignal an.

Es ist ein siebter MOS-Transistor T7 vorgesehen. Der siebte MOS-Transistor T7 ist ein n-Kanal-Transistor. Der zweite Anschluß des fünften MOS-Transistors T5 ist mit dem ersten Anschluß des siebten MOS-Transistors T7 verbunden. Der zweite Anschluß des siebten MOS-Transistors T7 ist mit der zweiten Versorgungsspannungsquelle VSS verbunden. Die Gate-Elektrode des siebten MOS-Transistors T7 wird mit dem digitalen Eingangssignal angesteuert. Die Gate-Elektrode des siebten MOS- Transistors T7 ist mit dem ersten Anschluß des dritten MOS- Transistors T3 verbunden. Die Gate-Elektrode des dritten MOS- Transistors T3 ist mit dem ersten Anschluß des siebten MOS- Transistors T7 verbunden.

Durch diese Verschaltung des dritten MOS-Transistors T3 und des siebten MOS-Transistors T7 wird jeweils der Teil der Schaltung, in dem ein niedriger Spannungspegel anliegt, auf das Potential der zweiten Versorgungspannungsquelle VSS gezogen.

Es ist ein achter MOS-Transistor T8 vorgesehen, der zum Beispiel ein n-Kanal-Transistor ist. Der erste Anschluß des achten MOS-Transistors T8 ist mit dem zweiten Anschluß des fünften MOS-Transistors T5 und dem zweiten Anschluß des sechsten MOS-Transistors T6 verbunden. Der zweite Anschluß des achten MOS-Transistors T8 ist mit Massepotential verbunden. Über die Gate-Elektrode des achten MOS-Transistors T8 wird das zweite Steuersignal S2 angelegt.

Durch Anlegen des zweiten Steuersignals S2 mit hohem Pegel werden der vierten MOS-Transistor T4 und der achten MOS-Transistor T8 leitend. Dadurch werden der zweite Anschluß des ersten MOS-Transistors T1 und der zweite Anschluß des fünften MOS-Transistors T5 auf Massepotential gelegt. Das bewirkt ein Löschen der in der Schaltungsanordnung zwischengespeicherten Information.

Wenn das Eingangssignal den Wert einer logischen 1 annimmt, wirken der zweite MOS-Transistor T2 und der erste Inverter I1 als Speicherglied. Nimmt das Eingangssignal den Wert einer logischen 0 an, wirken der sechste MOS-Transistor T6 und der vierte Inverter I4 als Speicherglied.

In der erfindungsgemäßen Schaltungsanordnung wird für das Ausgangssignal und für das invertierte Ausgangssignal der niedrige Spannungspegel durch entsprechende Verbindung mit der zweiten Versorgungsspannungsquelle VSS, der hohe Spannungspegel durch entsprechende Verbindung mit der ersten Versorgungsspannung VDD bereitgestellt. Darüberhinaus sind die beiden zueinander invertierten Schaltungszweige gegeneinander verriegelt.

Die Schaltungsanordnung ist als Adreßlatch für einen 16M-DRAM-Speicher geeignet.

## Patentansprüche

1. Schaltungsanordnung zum Zwischenspeichern eines Bits,
- bei der zwei Schaltungszweige vorgesehen sind, die einen gemeinsamen Eingang (E) aufweisen,
- bei der ein erster Schaltungszweig einen ersten MOS-Transistor (T1) und einen ersten Inverter (I1) umfaßt, die zwischen dem Eingang (E) und einem ersten Ausgang (A1) in Reihe verschaltet sind,
- bei der der erste MOS-Transistor (T1) bei Anliegen eines ersten Steuersignals (S1) ein dem Bit entsprechendes Eingangssignal auf den Eingang des ersten Inverters (I1) schaltet,
- bei der ein zweiter MOS-Transistor (T2), der ein p-Kanal-Transistor ist und der vom Ausgang des ersten Inverters (I1) angesteuert wird, zwischen den Eingang des ersten Inverters (I1) und eine erste Versorgungsspannungsquelle (V_{DD}), die ein dem höheren Pegel entsprechendes Potential liefert, geschaltet ist,
- bei der ein dritter MOS-Transistor (T3) der ein n-Kanal-Transistor ist, zwischen den Eingang des ersten Inverters (I1) und eine zweite Versorgungsspannungsquelle (VSS) geschaltet ist, die ein dem niedrigen Pegel entsprechendes Potential liefert,
- bei der ein vierter MOS-Transistor (T4) vorgesehen ist, der bei Anliegen eines zweiten Steuersignals (S2) ein am Eingang des ersten Inverters (I1) anliegendes Signal löscht,
- bei der der zweite Schaltungszweig einen dritten Inverter (I3), einen fünften MOS-Transistor (T5) und einen vierten Inverter (I4) umfaßt, die zwischen dem Eingang (E) und einem zweiten Ausgang (A2) in Reihe verschaltet sind,
- bei der der fünfte MOS-Transistor (T5) von dem ersten Steuersignal (S1) angesteuert wird und bei Anliegen des ersten Steuersignals (S1) den Ausgang des dritten Inverters (I3) mit dem Eingang des vierten Inverters (I4) verbindet,
- bei der ein sechster MOS-Transistor (T6), der ein p-Kanal-Transistor ist und der vom Ausgang des vierten Inverters (I4) angesteuert wird, zwischen den Eingang des vierten Inverters (I4) und die erste Versorgungsspannungsquelle (V_{DD}) geschaltet ist,
- bei der ein siebter MOS-Transistor (T7), der ein n-Kanal-Transistor ist, zwischen den Eingang des vierten Inverters (I4) und die zweite Versorgungsspannungsquelle (V_{SS}) geschaltet ist,
- bei der ein achter MOS-Transistor (T8) vorgesehen ist, der vom zweiten Steuersignal (S2) angesteuert wird und der bei Anliegen des zweiten Steuersignals (S2) ein am Eingang des vierten Inverters (I4) anliegende Signal löscht,
- bei dem das Gate des dritten MOS-Transistors (T3) mit dem Eingang des vierten Inverters (I4) und dem sechsten MOS-Transistor (T6) verbunden ist,
- bei dem das Gate des siebten MOS-Transistors (T7) mit dem Eingang des ersten Inverters (I1) und des zweiten MOS-Transistors (T2) verbunden ist.

2. Schaltungsanordnung nach Anspruch 1,
- bei der zwischen den Ausgang des ersten Inverters (I1) und den ersten Ausgang (A1) ein zweiter Inverter (I2) geschaltet ist,
- bei der zwischen den Ausgang des vierten Inverters (I4) und den zweiten Ausgang (A2) ein fünfter Inverter (I5) geschaltet ist.

3. Schaltungsanordnung nach Anspruch 1 oder 2,
- bei der der erste MOS-Transistor (T1), der vierte MOS-Transistor (T4), der fünfte MOS-Transistor (T5) und der achte MOS-Transistor (T8) jeweils n-Kanal-Transistoren sind.

4. Verwendung einer Schaltungsanordnung nach einem der Ansprüche 1 bis 3, als Adreßzwischenspeicher.

## Claims

1. Circuit arrangement for latching one bit,
- in which arrangement two circuit branches are provided which have a common input (E),
- in which a first circuit branch comprises a first MOS transistor (T1) and a first inverter (I1), which are connected in series between the input (E) and a first output (A1),
- in which, when a first control signal (S1) is present, the first MOS transistor (T1) switches an input signal corresponding to the bit to the input of the first inverter (I1),
- in which a second MOS transistor (T2) which is a p-channel transistor and which is acted upon by the output of the first inverter (I1), is connected between the input of the first inverter (I1) and a first supply voltage source (V_{DD}) which supplies a potential corresponding to the higher level,
- in which a third MOS transistor (T3), which is an n-channel transistor, is connected between the input of the first inverter (I1) and a second supply voltage source (V_{SS}) which supplies a potential corresponding to the low level,
- in which a fourth MOS transistor (T4) is provided which clears a signal present at the input of the first inverter (I1) when a second control signal (S2) is present,
- in which the second circuit branch comprises a third inverter (I3), a fifth MOS transistor (T5) and a fourth inverter (I4), which are connected in series between the input (E) and a second output (A2),
- in which the fifth MOS transistor (T5) is acted upon by the first control signal (S1) and, when the first control signal (S1) is present, connects the output of the third inverter (I3) to the input of the fourth inverter (I4),
- in which a sixth MOS transistor (T6), which is a p-channel transistor and is acted upon by the output of the fourth inverter (I4), is connected between the input of the fourth inverter (I4) and the first supply voltage source (V_{DD}),
- in which a seventh MOS transistor (T7), which is an n-channel transistor, is connected between the input of the fourth inverter (I4) and the second supply voltage source (V_{SS}),
- in which an eighth MOS transistor (T8) is provided, which is acted upon by the second control signal (S2) and which, when the second control signal (S2) is present, clears a signal present at the input of the fourth inverter (I4),
- in which the gate of the third MOS transistor (T3) is connected to the input of the fourth inverter (I4) and the sixth MOS transistor (T6),
- in which the gate of the seventh MOS transistor (T7) is connected to the input of the first inverter (I1) and the second MOS transistor (T2).

2. Circuit arrangement according to Claim 1,
- in which a second inverter (I2) is connected between the output of the first inverter (I1) and the first output (A1),
- in which a fifth inverter (I5) is connected between the output of the fourth inverter (I4) and the second output (A2).

3. Circuit arrangement according to Claim 1 or 2,
- in which the first MOS transistor (T1), the fourth MOS transistor (T4), the fifth MOS transistor (T5) and the eighth MOS transistor (T8) are in each case n-channel transistors.

4. Use of a circuit arrangement according to one of Claims 1 to 3 as an address latch.

## Revendications

1. Circuit pour la mise en mémoire intermédiaire d'un bit,
- selon lequel deux branches de circuit sont prévues qui ont une entrée commune,
- selon lequel une première branche de circuit comporte un premier transistor MOS (T1) et un premier inverseur (I1), lesquels sont montés en série entre l'entrée (E) et une première sortie (A1),
- selon lequel le premier transistor MOS (T1) applique un signal d'entrée correspondant au bit à l'entrée du premier inverseur (I1), lorsqu'un premier signal de commande (S1) est appliqué,
- selon lequel un deuxième transistor MOS (T2), qui est un transistor à canal P et qui est commandé par la sortie du premier inverseur (I1), est monté entre l'entrée du premier inverseur (I1) et une première source de tension d'alimentation (V_{DD}), laquelle fournit un potentiel correspondant au niveau supérieur,
- selon lequel un troisième transistor MOS (T3), qui est un transistor à canal N, est monté entre l'entrée du premier inverseur (I1) et une deuxième source de tension d'alimentation (VSS), laquelle fournit un potentiel correspondant au niveau inférieur,
- selon lequel un quatrième transistor MOS (T4) est prévu, qui efface un signal appliqué à l'entrée du premier inverseur (I1), lorsqu'un deuxième signal de commande (S2) est appliqué,
- selon lequel la deuxième branche de circuit comporte un troisième inverseur (I3), un cinquième transistor MOS (T5) et un quatrième inverseur (I4) qui sont montés en série entre l'entrée (E) et une deuxième sortie (A2),
- selon lequel le cinquième transistor MOS (T5) est commandé par le premier signal de commande (S1) et relie la sortie du troisième inverseur (I3) à l'entrée du quatrième inverseur (I4), lorsque le premier signal de commande (S1) est appliqué,
- selon lequel un sixième transistor MOS (T6), qui est un transistor à canal P et qui est commandé par la sortie du quatrième inverseur (I4), est monté entre l'entrée du quatrième inverseur (I4) et la première source de tension d'alimentation (V_{DD}),
- selon lequel un septième transistor MOS (T7), qui est un transistor à canal N, est monté entre l'entrée du quatrième inverseur (I4) et la deuxième source de tension d'alimentation (V_{SS}),
- selon lequel un huitième transistor MOS (T8) est prévu, qui est commandé par le deuxième signal de commande (S2) et qui efface un signal appliqué à l'entrée du quatrième inverseur (I4), lorsque le deuxième signal de commande (S2) est appliqué,
- selon lequel la grille du troisième transistor MOS (T3) est reliée à l'entrée du quatrième inverseur (I4) et du sixième transistor MOS (T6),
- selon lequel la grille du septième transistor MOS (T7) est reliée à l'entrée du premier inverseur (I1) et du deuxième transistor MOS (T2).

2. Circuit selon la revendication 1,
- selon lequel un deuxième inverseur (I2) est monté entre la sortie du premier inverseur (I1) et la première sortie du deuxième inverseur (I2),
- selon lequel un cinquième inverseur (I5) est monté entre la sortie du quatrième inverseur (I4) et la deuxième sortie (A2).

3. Circuit selon la revendication 1 ou 2,
- selon lequel le premier transistor MOS (T1), le quatrième transistor MOS (T4), le cinquième transistor MOS (T5) et le huitième transistor MOS (T8) sont chacun des transistors à canal N.

4. Utilisation d'un circuit selon l'une des revendications 1 à 3 comme mémoire intermédiaire d'adresses.
